(19) Europäisches Patentamt
European Patent Office
Office européen des brevets

(11) **EP 3 794 514 B1**

(12) **FASCICULE DE BREVET EUROPEEN**

(45) Date de publication et mention de la délivrance du brevet:
**22.11.2023 Bulletin 2023/47**

(21) Numéro de dépôt: **19722649.1**

(22) Date de dépôt: **13.05.2019**

(51) Classification Internationale des Brevets (IPC):
**G06N 3/065** *(2023.01)* **G06N 3/049** *(2023.01)*
**G06N 3/088** *(2023.01)*

(52) Classification Coopérative des Brevets (CPC):
**G06N 3/049; G06N 3/065; G06N 3/088**

(86) Numéro de dépôt international:
**PCT/EP2019/062223**

(87) Numéro de publication internationale:
**WO 2019/219618 (21.11.2019 Gazette 2019/47)**

(54) **SYNAPSE ARTIFICIELLE COMMUTEE**

GESCHALTETE KÜNSTLICHE SYNAPSE

SWITCHED ARTIFICIAL SYNAPSE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.05.2018 FR 1854010**

(43) Date de publication de la demande:
**24.03.2021 Bulletin 2021/12**

(73) Titulaires:
• **Université de Lille**
**59800 Lille (FR)**
• **Centrale Lille Institut**
**59651 Villeneuve-d'Ascq (FR)**
• **Université Polytechnique Hauts-de-France**
**59300 Valenciennes (FR)**
• **Centre National de la Recherche Scientifique**
**75016 Paris (FR)**
• **Yncrea Hauts de France**
**59800 Lille (FR)**

(72) Inventeurs:
• **DANNEVILLE, François**
**59000 LILLE (FR)**
• **CAPPY, Alain**
**59242 GENECH (FR)**
• **SOURIKOPOULOS, Ilias**
**59370 MONS EN BAROEUL (FR)**

• **LOYEZ, Christophe**
**62149 FESTUBERT (FR)**

(74) Mandataire: **Cabinet Nony**
**11 rue Saint-Georges**
**75009 Paris (FR)**

(56) Documents cités:
**FR-A1- 3 050 050**

• **S. PATIL ET AL: "Neural circuits for touch-induced locomotion in Caenorhabditis elegans", PROCEEDINGS OF THE 2015 INTERNATIONAL JOINT CONFERENCE ON NEURAL NETWORKS (IJCNN'15), 12 juillet 2015 (2015-07-12), XP033221889, DOI: 10.1109/IJCNN.2015.7280408**
• **J. V. Arthur, K. Boahen: "Learning in silicon: timing is everything", Proceedings of the 19th annual conference on Neural Information Processing Systems (NIPS'05), 5 décembre 2005 (2005-12-05), XP055010017, Extrait de l'Internet: URL:https://papers.nips.cc/paper/2859-learning-in-silicon-timing-is-everything.pdf [extrait le 2011-10-19]**
• **G. INDIVERI ET AL: "Neuromorphic silicon neuron circuits", FRONTIERS IN NEUROSCIENCE, vol. 5, 73, 31 mai 2011 (2011-05-31), XP055081025, DOI: 10.3389/fnins.2011.00073**

**Description**

La présente invention a pour objet un circuit à faible consommation d'énergie, pouvant reproduire certaines propriétés électriques d'une synapse biologique, et utilisable notamment dans des architectures bioinspirées.

L'invention concerne plus précisément une nouvelle topologie à commutation de synapses artificielles à faible puissance consommée, pouvant être associée à des neurones artificiels à haute efficacité énergétique.

Plusieurs travaux ont été réalisés pour modéliser le comportement biologique des neurones, tels les deux articles IEEE C. Mead et al. « Neuromorphic electronic systems », 1990 et E. Farquhar et al. « A bio-physically inspired silicon neuron », 2005.

La demande FR 3 050 050 décrit des circuits synaptiques en technologie CMOS classique associés à des neurones artificiels dont la consommation énergétique est de l'ordre du fJ par potentiel d'action.

L'article de J. Arthur et K. Boahen « Learning in silicon: timing is everything», Advances in Neuronal Information Processing Systems, 2006 propose un circuit CMOS modélisant la plasticité d'une synapse.

En 2015, Patil et al. (Neural circuits for touch-induced locomotion in Caenorhabditis elegans ; actes de IJCNN'15) ont décrit des circuits neuronaux électroniques comprenant des synapses excitatrices et inhibitrices connectant des pré-neurones à des post-neurones.

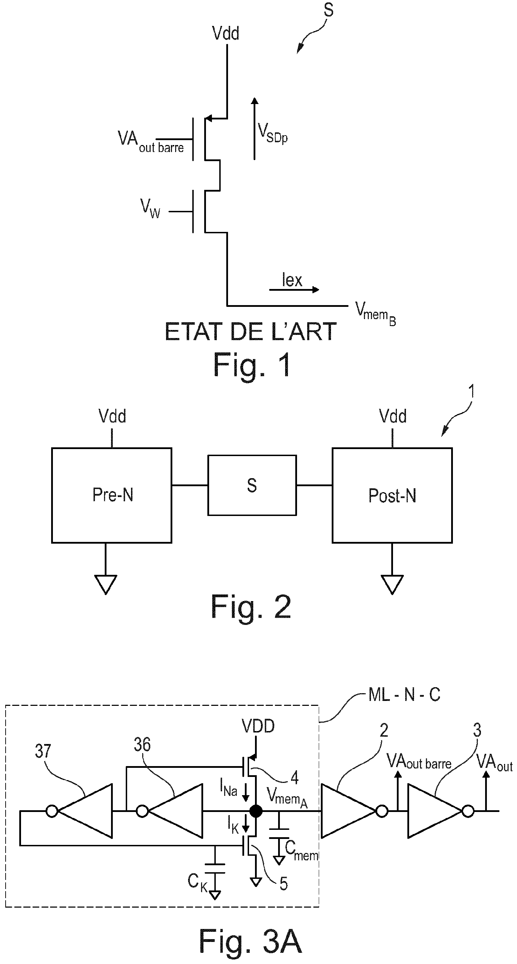

Une synapse excitatrice contribue au déclenchement d'un potentiel d'action par un neurone auquel elle est connectée en aval, dit post-neurone. Une synapse artificielle excitatrice classique comporte préférentiellement un transistor PMOS dont la source est connectée à une alimentation DC ($V_{dd}$) et dont le drain est relié à une capacité dite de membrane du post-neurone. La grille de ce transistor PMOS, lorsqu'aucun potentiel d'action n'est appliqué sur celle-ci, est isolée du canal conducteur. En ce sens, il existe une analogie formelle avec une synapse biologique, qui présente une « fente synaptique », isolant la partie axone provenant du pré-neurone de la partie dentrite connectée au post-neurone. Comme illustré à la figure 1 représentant une synapse excitatrice selon l'art antérieur, un transistor par exemple NMOS peut être prévu, dont le drain est relié à celui du transistor PMOS et dont la source est reliée à la capacité de membrane du post-neurone. La tension appliquée sur la grille de ce transistor NMOS est représentative d'un poids synaptique. Cette synapse artificielle excitatrice connue, couplée à un neurone artificiel énergétiquement efficace comme celui décrit à la demande FR 3 050 050, présente une consommation en mode statique (i.e. sans potentiel d'action activant la synapse) de l'ordre du pW, qui est pénalisante si l'on souhaite déployer des réseaux neuronaux à grande échelle, d'autant plus que le nombre de synapses peut être supérieur au nombre de neurones de plusieurs ordres de grandeur. En outre, le courant de fuite issu de la synapse excitatrice est de l'ordre de quelques pA. La somme des courants issus de synapses artificielles excitatrices appartenant à un même arbre dendritique peut être suffisante pour déclencher des potentiels d'action intempestifs au niveau du post-neurone. Cette génération de potentiels d'action présente deux inconvénients majeurs : (i) d'une part, ces potentiels d'action ne présentent pas d'intérêt en termes d'information utile au réseau neuronal, (ii) d'autre part, ils augmentent la consommation de puissance. Pour remédier à cet inconvénient, il est possible d'introduire une fuite, à l'aide d'un transistor NMOS utilisé en charge active, pour lequel grille et drain sont reliés, dimensionné afin d'empêcher le post-neurone de déclencher des potentiels d'action intempestifs. Cependant, cette solution est coûteuse en termes d'implantation, nécessitant un transistor supplémentaire par post-neurone, et pour des réseaux présentant des architectures complexes, peut s'avérer difficile à mettre en oeuvre. De surcroît, elle ne résout pas le problème relatif à la consommation statique.

Il n'existe pas à ce jour en technologie CMOS industrielle d'architecture de synapse excitatrice répondant de façon entièrement satisfaisante aux contraintes suivantes, lorsque la synapse est en mode statique:

- Une consommation de l'ordre du fW, garantie d'une possibilité de déploiement du réseau neuronal à grande échelle ;
- une architecture empêchant intrinsèquement le déclenchement de potentiel d'action d'un post-neurone, quelle que soit l'entrance du post-neurone, i.e. quel que soit le nombre de synapses excitatrices connectées à l'entrée d'un post-neurone.

L'invention a pour but de proposer une structure de synapse artificielle pouvant répondre à tout ou partie de ces contraintes. L'invention est définie dans les revendications.

Par « état complémentaire » d'un signal, il faut comprendre l'état dans lequel serait ce signal à la sortie d'un inverseur logique.

Grâce à l'invention, la puissance consommée est réduite par rapport à celle d'un circuit neuronal utilisant une synapse excitatrice connue, et le risque de génération d'un potentiel d'action intempestif au niveau du post-neurone est réduit, voire supprimé.

Les synapses objet de l'invention sont réalisées en une technologie de transistors à effet de champ pouvant être organiques ou CMOS, par exemple. Les pré-neurones et/ou post-neurones associés peuvent être réalisés en la même technologie ou en une technologie différente. Par exemple, les synapses sont réalisées avec des transistors organiques et les neurones avec des transistors CMOS, et vice versa.

L'invention permet d'utiliser des transistors fonctionnant sous le seuil. Le fonctionnement des transistors sous le seuil correspond à l'existence d'un courant drain-source variant exponentiellement avec la tension de commande de grille dans la région dite d'inversion faible du transistor ('weak-inversion région' ou 'subthreshold région' en anglais), où la tension grille-source est en deçà de la tension de seuil pour laquelle la zone d'inversion apparaît (création d'un canal de conduction entre le drain et la source). Il est à noter que la tension drain-source est inférieure à la tension de seuil si la tension d'alimentation $V_{dd}$ est elle-même inférieure à la tension de seuil, favorisant une faible consommation de puissance des transistors.

La synapse excitatrice comporte au moins deux transistors à effet de champ, préférentiellement CMOS, dont les canaux drain-source sont en série, de manière à former une chaîne de transistors en série entre un point de potentiel connecté à $VA_{out}$ et un point de potentiel connecté au potentiel de membrane du post-neurone, les transistors situés aux extrémités de la chaîne étant qualifiés de « transistors d'extrémité ».

Le « potentiel de membrane » désigne le potentiel à la borne de la capacité de membrane du neurone.

De préférence, le transistor d'extrémité connecté à $VA_{out}$ est un transistor PMOS et le transistor d'extrémité connecté au potentiel de membrane ($V_{memB}$) du post-neurone est un transistor NMOS.

Dans un exemple de mise en oeuvre, la chaîne de transistors ne comprend que deux transistors qui constituent les transistors d'extrémité, ces transistors ayant leurs sources au même potentiel lorsque $VA_{out}$ = 0.

L'un des transistors d'extrémité, préférentiellement du type PMOS, a une grille définissant l'entrée de commutation et l'autre transistor d'extrémité, préférentiellement du type NMOS, a une grille définissant une entrée de potentiel de poids synaptique.Le potentiel de poids synaptique, appliqué à l'entrée de potentiel de poids synaptique, peut être analogique ou binaire, prenant préférentiellement une valeur adéquate parmi $V_{dd}$ et 0, lorsque le circuit est alimenté par une tension $V_{dd}$.

La synapse peut comporter au moins un troisième transistor intermédiaire à effet de champ, préférentiellement CMOS, appartenant à la chaîne de transistors, et disposé entre lesdits transistors d'extrémité, la grille de ce troisième transistor étant reliée au drain ou à la source de l'un des transistors d'extrémité. Ce troisième transistor permet de contrôler le courant synaptique en ajustant son intensité.

De préférence, la tension d'alimentation $V_{dd}$ est telle que $0 < V_{dd} < 0,3$ V, mieux $0 < V_{dd} < 0,25$ V, encore mieux $0 < V_{dd} < 0,2$ V.

Le pré-neurone comporte avantageusement deux inverseurs en cascade, dénommés premier et second inverseurs conformateurs, générant respectivement les tensions $VA_{out\_barre}$ et $VA_{out}$.

Le potentiel de poids synaptique binaire appliqué à l'entrée de potentiel de poids synaptique est, de préférence, obtenu en sortie d'un circuit de détermination du poids synaptique, ce circuit de détermination du poids synaptique pouvant comprendre :

- Un circuit mémoire, de préférence à base de SRAM, (« Static Random Access Memory ») ayant pour entrée une tension analogique $V_{w\ analogique}$ et pour sortie le potentiel de poids synaptique binaire et comportant :

    o Une cellule mémoire, de préférence SRAM comportant deux inverseurs dont l'entrée de l'un est connectée à la sortie de l'autre, ayant pour sortie un point de connexion définissant le potentiel de poids synaptique binaire,
    ∘ Deux transistors à effet de champ, préférentiellement CMOS, encore plus préférentiellement NMOS, dont les canaux drain-source sont en série, recevant sur la grille de l'un d'entre eux la tension analogique $V_{w\ analogique}$, et le drain ou la source de ce dernier définissant l'entrée de la cellule mémoire, et sur la grille de l'autre transistor le potentiel $VB_{out}$ de sortie du post-neurone.

- Un circuit d'apprentissage, dit STDP (« Spike Timing Dépendent Plasticity »), comportant de préférence:

    ∘ Deux transistors à effet de champ, préférentiellement CMOS, encore plus préférentiellement de type PMOS, reliés en série, le premier transistor ayant la source connectée au potentiel $VB_{out}$ de sortie du post-neurone, la grille connectée à un état complémentaire $VB_{out\ barre}$ de ce potentiel et le drain connecté à la source du deuxième transistor, dont le drain est connecté à une borne d'une première capacité intégrant le potentiel de poids synaptique, l'autre borne de cette première capacité étant reliée à la masse, le drain du deuxième transistor fournissant la tension analogique $V_{w\ analogique}$ au circuit mémoire,
    ∘ un troisième transistor à effet de champ, préférentiellement CMOS, encore plus préférentiellement PMOS, dont la source est reliée au potentiel $VA_{out}$ du pré-neurone, la grille est reliée à la masse et le drain relié à une borne d'une deuxième capacité dont l'autre borne est reliée à la masse, et
    o un inverseur dont l'entrée est reliée au drain du troisième transistor et la sortie est reliée à la grille du deuxième transistor.

Le circuit d'apprentissage STDP met en oeuvre un protocole traduisant la plasticité de la synapse, où le poids de celle-ci dépend des positions relatives dans le domaine temporel des potentiels d'action du pré-neurone et du post-neurone. Si le potentiel d'action du post-neurone est en retard par rapport à celui du pré-neurone, le poids va se renforcer et inversement si le potentiel d'action du post-neurone est en avance par rapport à celui du pré-neurone, le poids va diminuer.

Le circuit d'apprentissage STDP permet ainsi un apprentissage lors du fonctionnement du circuit, dit « online », du potentiel de poids synaptique, où ce dernier est renforcé ou diminué en fonction du retard entre les potentiels d'action du pré-neurone et du post-neurone.

Une autre possibilité est un apprentissage dit « offline », consistant à prédéterminer les poids synaptiques extérieurement au circuit neuronal, par exemple suite à une simulation effectuée sur ordinateur, puis à les injecter dans ce circuit, par exemple à l'aide d'une mémoire électronique.

Le circuit d'apprentissage STDP peut être réalisé en variante en une technologie à base de memristors.

Le circuit de détermination du poids synaptique peut avoir une réplique symétrique dans laquelle les potentiels $VA_{out}$ et $VB_{out}$ sont permutés, la symétrie étant par rapport à la cellule mémoire qui est partagée en commun entre le circuit de détermination du poids synaptique et sa réplique, un potentiel de poids synaptique binaire appliqué à une entrée de potentiel de poids synaptique d'une synapse inhibitrice étant prélevé à un point de connexion opposé au point de connexion définissant le potentiel de poids synaptique binaire de la synapse excitatrice.

De préférence, le pré-neurone comporte un sous-circuit d'extension comportant deux inverseurs en cascade, dits de couplage, suivis d'un circuit intégrateur comprenant un transistor à effet de champ, préférentiellement CMOS, et une capacité, la grille du transistor étant reliée au drain constituant la sortie des deux inverseurs de couplage en cascade, la source du transistor étant reliée à une première borne de la capacité dont la deuxième borne est reliée à la masse, la sortie du sous-circuit d'extension étant reliée à l'entrée du premier inverseur conformateur.

Ce sous-circuit d'extension permet d'étendre la durée du potentiel post-synaptique excitateur (PPSE), qui peut être défini par un changement de la valeur du potentiel de membrane du post-neurone, dans le sens d'une dépolarisation. Ce sous-circuit peut aussi être utilisé pour l'hyperpolarisation d'un post-neurone provoquée par une synapse inhibitrice.

Le transistor du sous-circuit d'extension est préférentiellement de type CMOS, encore plus préférentiellement NMOS.

L'un au moins des pré-neurone et post-neurone peut être de type Morris-Lecar, comportant de préférence:

- une capacité dite de membrane dont l'une des bornes définit un potentiel de membrane,
- un circuit impulsionnel à contre-réaction comportant :

  ◦ un pont à transistors à effet de champ, préférentiellement CMOS, encore plus préférentiellement PMOS et NMOS, en série et reliés avec leurs drains au potentiel de membrane, et
  ◦ au moins une capacité, dite de retard, entre la grille et la source de l'un des transistors du pont, et

- au moins deux inverseurs à effet de champ, préférentiellement CMOS, en cascade, chacun étant constitué de deux transistors, l'entrée du premier inverseur étant reliée à la capacité de membrane et sa sortie à l'entrée du deuxième inverseur et à la grille de l'un des transistors du pont, la sortie du deuxième inverseur étant reliée à la grille de l'autre transistor du pont, ou
- au moins trois inverseurs à effet de champ, préférentiellement CMOS, dont deux inverseurs sont en cascade, chacun étant constitué de deux transistors, l'entrée du premier inverseur étant reliée à la capacité de membrane et sa sortie à l'entrée du deuxième inverseur, la sortie du deuxième inverseur étant reliée à la grille de l'un des transistors du pont, l'entrée du troisième inverseur étant reliée à la capacité de membrane et la sortie du troisième inverseur CMOS étant reliée à la grille de l'autre transistor du pont.

De préférence, les largeurs de grille des transistors du pré-neurone et/ou post-neurone de type Morris-Lecar sont comprises entre 60 nm et 10 $\mu$m, préférentiellement entre 120 nm et 2 $\mu$m, les longueurs de grille de ces transistors sont comprises entre 10 nm et 10 $\mu$m, préférentiellement entre 28 nm et 500 nm et les valeurs des capacités de membrane et de retard sont comprises entre 1 fF et 1 pF, préférentiellement entre 4fF et 200fF.

L'un au moins des pré-neurone et post-neurone peut aussi être de type Axon-Hillock, comportant de préférence:

- au moins deux inverseurs en cascade,
- une capacité de contre-réaction montée en parallèle desdits au moins deux inverseurs en cascade, et
- un transistor NMOS dont le drain définit un potentiel de membrane qui est l'entrée desdits au moins deux inverseurs en cascade et dont la grille est reliée à leur sortie, la source étant reliée à la masse.

De préférence, le nombre d'inverseurs en cascade est pair.

Le pré-neurone ou le post-neurone Axon-Hillock peut en outre comporter une capacité de membrane connectée entre l'entrée du premier inverseur et la masse.

L'entrée du premier inverseur conformateur est préférentiellement connectée au potentiel de membrane, aussi bien dans le cas du neurone de type Morris-Lecar que celui de type Axon-Hillock.

Le premier inverseur conformateur permet d'avoir une impédance élevée en sortie du neurone. Ceci permet de ne pas perturber la capacité de membrane du pré-neurone.

Une largeur de grille relativement faible des transistors du premier inverseur conformateur permet d'avoir une faible capacité intrinsèque.

Le pré-neurone peut être connecté à sa sortie à plusieurs synapses définissant la sortance de ce neurone, i.e. le nombre maximal de connexions ou « axonal tree » en anglais.

Le post-neurone peut recevoir en entrée les signaux de plusieurs synapses dont le nombre maximal définit l'entrance du neurone.

De préférence, les largeurs de grille des transistors du pré-neurone et/ou post-neurone de type Axon-Hillock sont comprises entre 60 nm et 10 $\mu$m, préférentiellement entre 120 nm et 2 $\mu$m, les longueurs de grille de ces transistors sont comprises entre 10 nm et 10 $\mu$m, préférentiellement entre 28 nm et 500 nm et la capacité de contre-réaction est comprise entre 1 fF et 1 pF, préférentiellement entre 4fF et 200fF.

Ces valeurs permettent d'obtenir de bonnes performances en termes d'efficacité énergétique.

Le circuit neuronal peut comporter en outre au moins une synapse inhibitrice comprenant au moins deux transistors à effet de champ, préférentiellement CMOS, encore plus préférentiellement NMOS, dont les canaux drain-source sont en série, l'un des deux transistors ayant sa grille connectée à la tension de sortie VA $_{out}$ du pré-neurone, sa source connectée à la masse et son drain connecté à la source de l'autre transistor, ce dernier ayant sa grille connectée à un potentiel de poids synaptique et son drain connecté au potentiel de membrane du post-neurone.

Le terme « capacité » peut désigner à la fois un condensateur en tant que composant et sa capacité électrique en tant que grandeur physique, mesurée en Farads (F).

L'invention pourra être mieux comprise à la lecture de la description qui va suivre, d'exemples non limitatifs de mise en oeuvre de celle-ci, et à l'examen du dessin annexé, sur lequel :

- la figure 1, précédemment décrite, illustre une synapse excitatrice classique de l'art antérieur,
- la figure 2 représente de façon schématique l'interconnexion entre synapse et pré et post-neurones,
- les figures 3A et 3B illustrent deux variantes d'architecture de neurones de type Morris-Lecar à deux et à trois inverseurs respectivement,
- la figure 4 représente une architecture de neurone de type Axon-Hillock,
- la figure 5 représente un circuit neuronal selon un premier mode de réalisation de l'invention,
- les figures 6 et 7 sont des schémas équivalents d'une synapse selon l'invention, en mode statique,
- la figure 8 illustre les formes d'onde obtenues par simulation numérique du circuit de la figure 5 en présence d'un potentiel d'action généré par le pré-neurone de type Morris-Lecar,
- la figure 9 représente une variante de synapse selon l'invention,
- la figure 10 illustre un circuit neuronal selon un deuxième mode de réalisation de l'invention, réalisable avec des neurones de type Morris-Lecar ou Axon-Hilock,
- la figure 11 représente les formes d'onde des potentiels, obtenues par simulation numérique du circuit de la figure 10, dans le cas de neurones de type Morris-Lecar,
- la figure 12A illustre un exemple de circuit de détermination de poids synaptique pour une synapse excitatrice,
- la figure 12B complète la figure 12A par un circuit symétrique de détermination de poids synaptique pour une synapse inhibitrice,
- la figure 13 représente le schéma du circuit de simulation numérique pour le neurone Axon-Hillock,
- la figure 14 illustre les formes d'onde obtenues à partir de la simulation numérique du circuit de la figure 13,
- la figure 15 représente une variation expérimentale de la fréquence des potentiels d'action et de la puissance consommée pour le neurone Axon-Hillock en fonction du courant délivré par l'alimentation,
- la figure 16 illustre l'énergie par potentiel d'action,tenant compte des puissances statique et dynamique, du neurone Axon-Hillock en fonction de la fréquence des potentiels d'action, et
- la figure 17 représente un exemple de synapse inhibitrice pouvant faire partie du circuit neuronal selon l'invention.

On a illustré à la figure 2 le principe d'interconnexion entre une synapse S et un pré-neurone Pre-N la précédant et un post-neurone Post-N lui succédant. Un tel circuit neuronal 1, alimenté par exemple par une tension $V_{dd}$, constitue la brique de base d'un réseau neuronal.

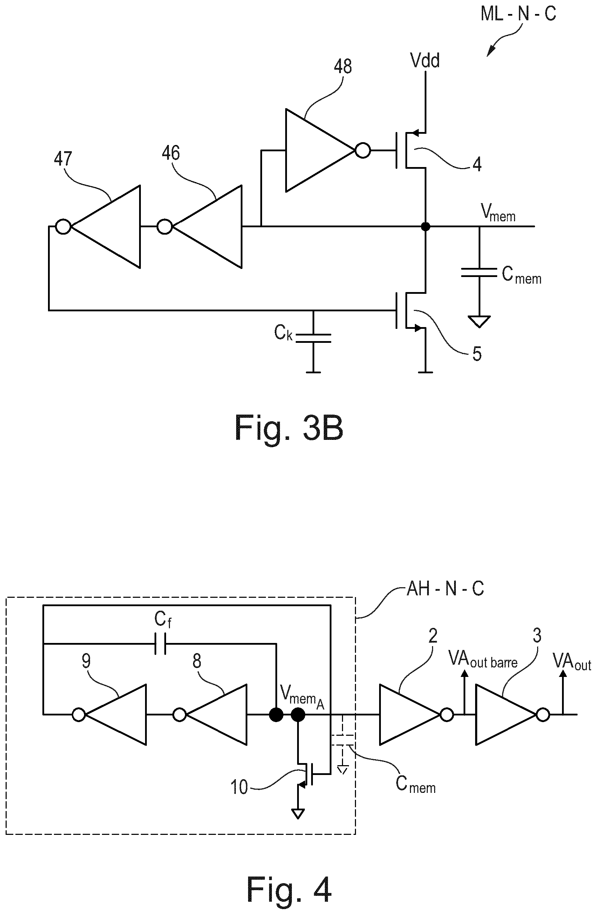

Le pré et le post-neurone peuvent être de type Morris-Lecar ou Axon-Hillock. Dans les deux cas, le circuit comporte en sortie deux inverseurs 2 et 3 en cascade générant respectivement des tensions de sortie VA$_{out\ barre}$ et VA$_{out}$, comme illustré à la figure 3A ou figure 4.

La figure 3A représente un exemple de coeur « ML-N-C » de neurone Morris-Lecar comportant une capacité

dite de membrane $C_{mem}$ dont l'une des bornes définit un potentiel de membrane $V_{mem}$. ML-N-C comporte aussi deux transistors PMOS 4 et NMOS 5 en série dont les courants de drain $I_{Na}$ et $I_K$ correspondent respectivement aux courants sodique et potassique en biologie, une capacité $C_K$ dite de retard entre la grille du transistor NMOS 5 et la masse pour générer un décalage temporel de conduction/blocage entre les deux transistors, et deux inverseurs CMOS 36 et 37 en cascade entre la capacité de membrane $C_{mem}$ et les grilles des transistors 4 et 5.

En biologie, la variation du courant sodique $I_{Na}$ et du courant potassique $I_K$ en fonction de la variation du potentiel de membrane $V_{mem}$ est de l'ordre de 10 mV par décade de courant. La limite théorique de la pente sous le seuil des transistors MOS étant 60 mV/décade, une valeur communément observée en pratique est de 90 mV/décade. Les inverseurs en cascade 36 et 37 opèrent comme amplificateurs de tension afin d'atteindre des variations des courants $I_{Na}$ et $I_K$ par rapport aux variations de tension de membrane semblables à la biologie. On peut montrer analytiquement que le gain en tension maximum $G_v$ des inverseurs s'exprime ainsi :

$$Gv = \frac{\left(e^{\left(\frac{Vdd}{2*Vt}\right)}-1\right)}{n} \cdot \frac{\left(1+\frac{Vdd}{2*Va}\right)}{\left(1+\frac{Vt.e^{\left(\frac{Vdd}{2*Vt}\right)}}{Va}\right)} \quad Gv = \frac{\left(e^{\left(\frac{Vdd}{2*Vt}\right)}-1\right)}{n} \cdot \frac{\left(1+\frac{Vdd}{2*Va}\right)}{\left(1+\frac{Vt.e^{\left(\frac{Vdd}{2*Vt}\right)}}{Va}\right)}$$

$$\left(\overline{Va} = 2 * \frac{1}{\frac{1}{Van}+\frac{1}{Vap}}\right)$$

avec

$Vt=k.T/q$ est la tension thermique, $n$ est le coefficient d'idéalité extrait des caractéristiques $I_d=f(V_{gs})$ des transistors MOS ($n \approx 1.5$) et $\overline{Va}$ est représentative des tensions dites d'Early du PMOS et du NMOS. Il faut souligner que ce gain est indépendant de la géométrie des transistors (longueur et largeur de grille), mais dépend de la tension d'alimentation $V_{dd}$, qui doit être suffisante. Pour la technologie TSMC, et en prenant $V_{dd} = 200mV$, $Gv \approx 5$. Ainsi, la variation du courant sodique en fonction de la variation de $V_{mem}$ sera de l'ordre de $\left[\left(\frac{90}{5}\right) = 18\right]$ mV par décade de courant, ce qui est proche de la biologie. Pour le courant potassique, l'effet sera encore plus important car c'est le gain en tension des deux inverseurs qui est à considérer.

La figure 3B représente une variante de coeur ML-N-C de neurone Morris-Lecar, qui diffère de celle de la figure 3A par l'ajout d'un troisième inverseur 47, le premier inverseur 48 transmettant le potentiel de sortie après inversion à la grille du transistor PMOS 4 du pont et les deux autres inverseurs 46 et 47, reliés en cascade, transmettant le potentiel de sortie à la grille du transistor NMOS 5.

Les entrées des inverseurs 46 et 48 sont reliées au potentiel de membrane et à la capacité d'intégration, et l'entrée de l'inverseur 47 est reliée à la sortie de l'inverseur 46.

L'ajout du troisième inverseur permet d'optimiser de façon indépendante les commandes des transistors du pont, en réglant indépendamment les tensions de seuil des inverseurs.

La figure 4 illustre un exemple de coeur « AH-N-C » d'un neurone Axon-Hillock qui comporte deux inverseurs en cascade 8 et 9, une capacité $C_f$ de contre-réaction montée en parallèle de ces inverseurs et un transistor NMOS 10 dont le drain définit le potentiel de membrane $V_{mem}$, la source est connectée à la masse et la grille est reliée à la sortie des inverseurs 8 et 9. Ce neurone peut aussi comporter une capacité de membrane $C_{mem}$ connectée entre l'entrée du premier inverseur 8 et la masse, et représentée en pointillés sur la figure 4.

Il faut souligner que les deux inverseurs 8 et 9 du coeur AH-N-C jouent le même rôle que celui décrit précédemment pour le ML-N-C. Néanmoins, les formes d'onde obtenues pour la tension de membrane avec le coeur AH-N-C sont plus éloignées de la biologie par rapport au coeur ML-N-C.

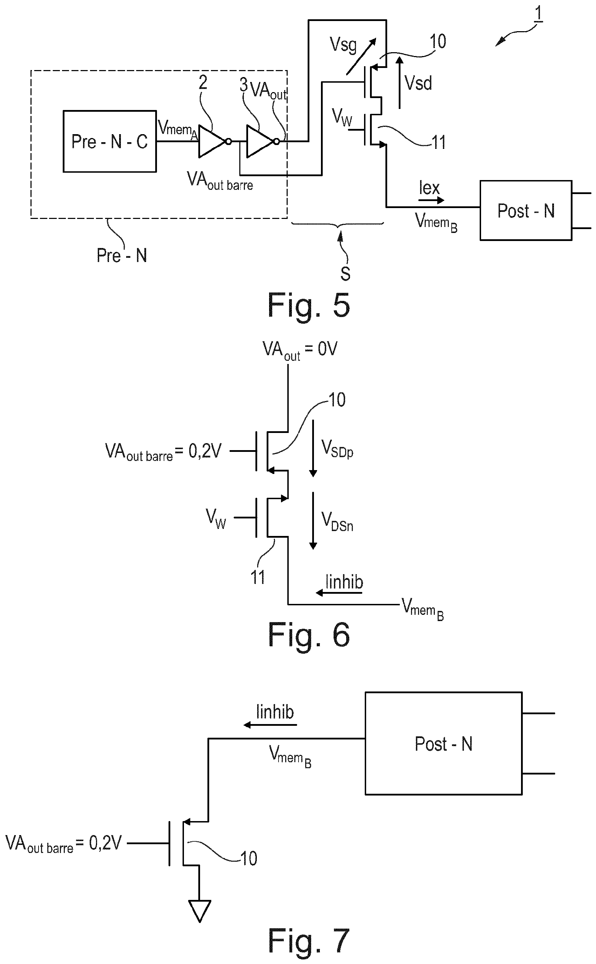

La figure 5 représente un premier mode de réalisation d'un circuit neuronal 1 selon l'invention. Ce circuit un pré-neurone Pre-N et un post-neurone Post-N reliés entre eux par une synapse S. Celle-ci est composée de deux transistors CMOS en série reliés par leurs drains: un transistor PMOS 10 et un transistor NMOS 11. La grille du transistor PMOS 10, constituant l'entrée de commutation de la synapse, est reliée au signal $VA_{out\ barre}$ provenant du pré-neurone Pre-N. La source du transistor 10 est reliée au signal $V_{out}$. La grille du transistor NMOS 11 définit le potentiel de poids synaptique $V_w$, lequel peut varier pour traduire la plasticité de la synapse. La source du transistor 11 va à l'entrée du post-neurone Post-N de telle sorte que le courant $I_{ds}$ entre drain et source constitue un courant d'excitation $I_{ex}$ pour le post-neurone.

En mode statique, lorsque le pré-neurone ne génère pas de potentiel d'action, autrement dit lorsque $VA_{out} =$

0V, le transistor NMOS 11 est pratiquement transparent pour l'analyse du fonctionnement, quel que soit le potentiel de poids synaptique $V_w$, car sa tension drain-source est quasi nulle. Le post-neurone de type Morris-Lecar n'étant pas excité, sa tension de membrane qui est positive est de l'ordre de quelques dizaines de mV. Ainsi, la tension $V_{sd}$ du transistor PMOS 10, telle qu'illustrée sur la figure 5, est négative, ce qui implique que source et drain peuvent être inversés pour les deux transistors 10 et 11, comme représenté à la figure 6. Le courant $I_{ex}$ est négatif et aucun potentiel d'action ne pourra être généré au niveau du post-neurone, celui-ci se trouvant au repos. La synapse est équivalente à une charge active représentée à la figure 7, produisant un courant inhibiteur $I_{inhib}$.

Des simulations numériques sur le logiciel LTspice ont été faites du circuit équivalent de la figure 6 et du circuit de la synapse classique de la figure 1 pour comparer les courants $I_{inhib}$ et $I_{ex}$. Pour ces simulations, $V_{dd} = V_w = 0,2V$ et la longueur et la largeur de la grille des transistors ont été fixées à 65nm et 120nm respectivement.

Les résultats de ces simulations ont révélé un courant $I_{inhib} = 10$ fA contre un courant $I_{ex} = 2,5$ pA, soit plus de deux ordres de grandeur inférieur. La puissance dissipée par la synapse de la figure 6 est égale à 0,15 fW alors que celle dissipée par la synapse classique est égale à 0,45 pW. Une synapse selon l'invention peut permettre une diminution de la puissance dissipée supérieure à 3 ordres de grandeur par rapport à une synapse classique.

Il est à noter que dans le cas de neurones de type Axon-Hilock et sans activité d'un pré-neurone, la tension de membrane dudit neurone Axon-Hilock est quasi nulle, et dans ce cas l'utilisation d'une synapse commutée avec ce(s) neurone(s) Axon-Hilock permet d'obtenir une puissance quasi nulle et dans tous les cas inférieure à celle que l'on obtiendrait dans une configuration mettant en oeuvre un (des) neurone(s) de type Morris-Lecar.

A partir des circuits des figures 1 et 6, il est possible de confirmer ces valeurs par le calcul.

On a, comme équations pour les courants de drain Idp et Idn des transistors PMOS et NMOS, respectivement:

$$Idp = Is'. e^{\frac{Vsg_p}{n.Vt}}.\left(1 - e^{\frac{-Vsd_p}{Vt}}\right)$$

$$Idn = Is''. e^{\frac{Vgs_n}{n.Vt}}.\left(1 - e^{\frac{-Vds_n}{Vt}}\right)$$

Is' correspond au courant de fuite en saturation du transistor PMOS ($V_{sg} = 0V$ et $V_{sd} > 5.V_t$).

$I_s''$ correspond au courant de fuite en saturation du transistor NMOS ($V_{gs} = 0V$ et $V_{ds} > 5.V_t$)
Pour le circuit de la figure 1, lorsque le pré-neurone ne génère pas de potentiel d'action, $Vsg_p = V_s - V_g = V_{dd} - VA_{out\ barre} = 0V$. $Vgs_n = V_{dd} - V_{mem}$, avec $V_{mem}$ égale à 25mV (valeur donnée par la simulation LTspice). D'où $Vgs_n = 175mV$ si $V_W = V_{dd}$.

Les courants Idp et Idn étant identiques, il résulte des valeurs respectives de $Vgs_p$ et $Vgs_n$ que la tension $Vds_n$ du NMOS est très faible ($Vds_n \ll 1mV$).

En négligeant la tension $Vds_n$, $Vsd_p = V_{dd} - V_{mem} = 175mV$.

Il résulte que $Lex = Ldp \approx Is' = 2.5$ pA
La puissance en mode statique dissipée par une synapse classique est essentiellement due au transistor PMOS : $P_{DC} = Vsd_p * lex = 0.45$ pW. Il est à noter que si $V_W = 0$ V, le courant traversant les deux transistors reste du même ordre de grandeur, avoisinant les 2 pA.

En ce qui concerne le circuit de la figure 6, compte tenu de la valeur extrêmement faible de $I_{inhib}$, la tension de membrane du post-neurone Post-N est proche de 15mV (valeur donnée par la simulation LTspice). Puisque $VA_{out\ barre} = 0.2$V, la tension $Vsg_p$ du transistor 10 sera comprise entre -0.2 V et -0.185 V, entraînant de facto un courant <u>extrêmement</u> faible.

Puisque les courants Idp et Idn sont identiques, il résulte que la tension $Vds_n$ est proche de 0V, quelque soit la valeur du poids $V_W$ D'où,

$$Vsg_D = (V_{mem} - VA_{out\ barre}) \approx (15 - 200)mV \approx -185mV.$$

$$Vsd_p = V_{mem} - VA_{out} \approx 15 mV.$$

$$Idp = Is'. e^{\frac{-185}{40}}.\left(1 - e^{\frac{-15}{25}}\right) \approx 4.4 \ 10^{-3}.Is' \ (< 10^{-2}.Is')$$

*linhib* = 4.4 $10^{-2}$. *Iex*(*SA* "standard") = 10 *fA* Donc, $I_{inhib}$ = 4,4 $10^{-3}.I_{ex}$ = 10 fA.

La puissance en mode statique dissipée par la synapse est celle du transistor PMOS : $P_{DC}$ = $Vsd_p$ * Idp = 0,15 fW.

Les valeurs des courants et puissances calculées correspondent bien à celles trouvées par les simulations numériques.

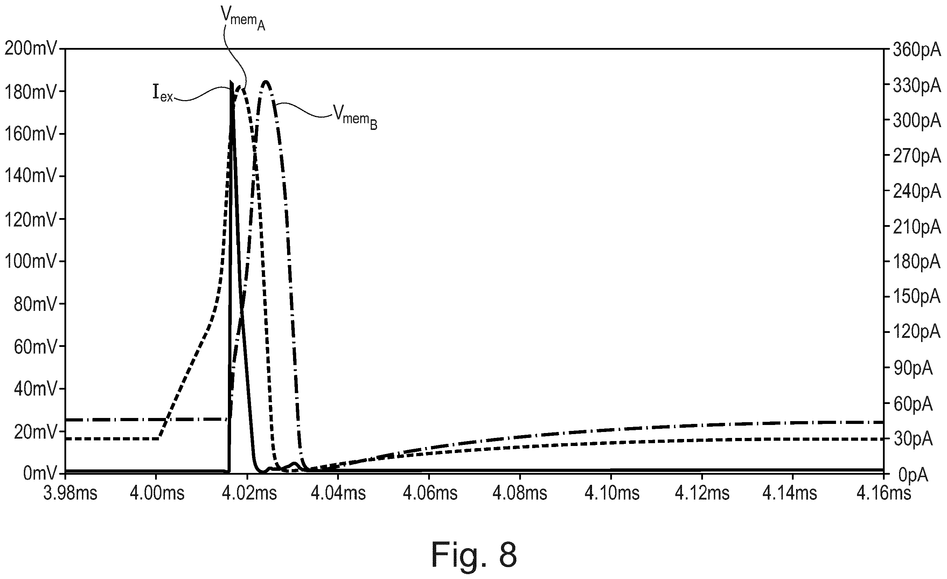

En simulant le circuit de la figure 5 sur LTspice, on a excité le pré-neurone et observé la réponse du courant d'excitation $I_{ex}$ issu de la synapse, ainsi que le potentiel d'action du post-neurone. Les résultats des formes d'onde obtenues sont rapportés sur la figure 8.

On observe qu'à l'arrivée du potentiel d'action du pré-neurone (la courbe $V_{memA}$), le courant $I_{ex}$ augmente avec une amplitude très importante, déclenchant un potentiel d'action (courbe $V_{memB}$) au niveau du post-neurone légèrement en retard.

Ces formes d'onde sont similaires à celles obtenues en remplaçant la synapse selon l'invention par une synapse classique selon la figure 1.

En technologie CMOS 65nm, en imposant une longueur de grille nominale de 65nm pour les transistors, cela se traduit par un courant synaptique en mode dynamique, i.e. lors d'un potentiel d'action du pré-neurone, qui reste trop élevé, même pour la largeur de grille minimale réalisable (120nm).

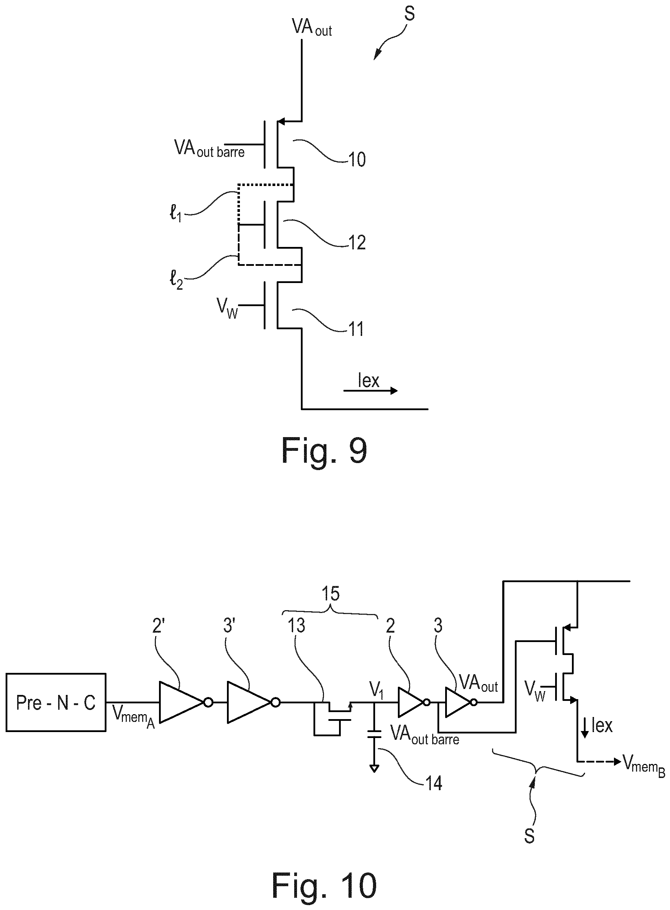

Afin de contrôler le courant synaptique, un transistor supplémentaire 12 peut être intercalé en série entre les transistors 10 et 11 de la synapse S, comme représenté à la figure 9. Ce transistor 12 peut être indifféremment de type NMOS ou PMOS. Sa grille est reliée à son drain ou sa source selon la liaison 11 ou 12.

Il à noter que les dimensions des transistors de la figure 9 sont des éléments pouvant contribuer au réglage du courant synaptique.

Si l'on considère le circuit de la figure 5, la durée du potentiel post-synaptique excitateur (PPSE) est la même que celle du potentiel d'action du pré-neurone. Afin d'étendre la durée du PPSE (par exemple jusqu'à 10 fois la largeur d'impulsion relative à un potentiel d'action), le deuxième mode de réalisation de l'invention illustré à la figure 10 met en cascade à la sortie du coeur Pre-N-C du pré-neurone deux inverseurs 2' et 3' suivis d'un intégrateur 15 comportant une charge active constituée préférentiellement d'un transistor NMOS 13 dont la grille et le drain sont reliés et une capacité 14 reliée à la masse.

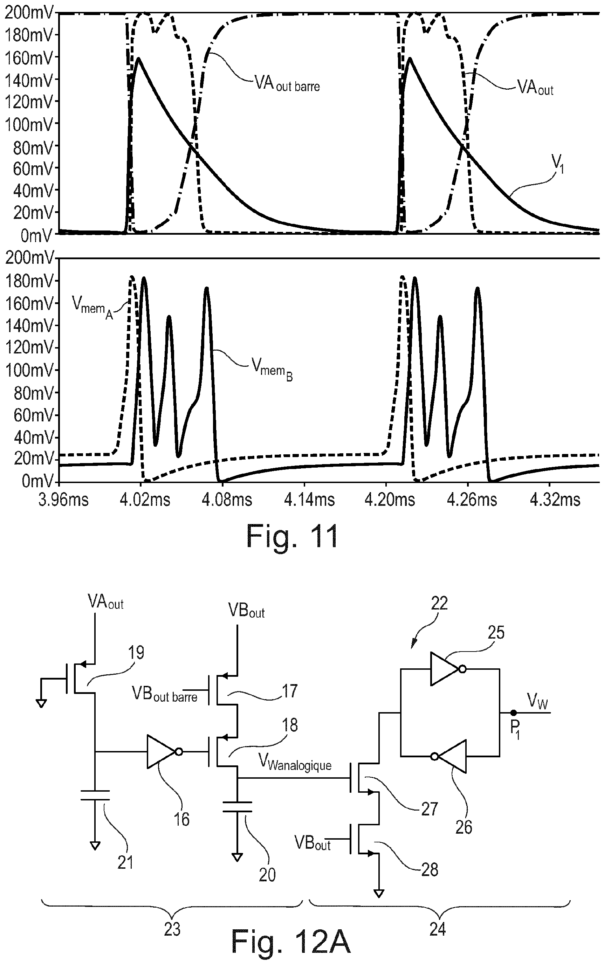

Les courbes de $VA_{out}$, $VA_{out\ barre}$ et la tension $V_1$ à la sortie de l'intégrateur 15 sont illustrées à la figure 11. Cette figure représente aussi les potentiels de membrane $V_{memA}$ et $V_{memB}$ des pré-neurone et post-neurone respectivement. On observe que la réponse à un seul potentiel d'action du pré-neurone se traduit par la présence de trois potentiels d'action pour le post-neurone, du fait du maintien de $V_{out}$ pour une durée étendue à $V_{dd}$, grâce à l'intégrateur 15.

Pour traduire d'un point de vue artificiel la STDP, on a représenté à la figure 12A un exemple de circuit 22 servant à déterminer au point P1 le potentiel poids synaptique binaire $V_w$ à partir des tensions de sortie $VA_{out}$ et $VB_{out}$ du pré-neurone et post-neurone respectivement. Ce circuit 22 comprend un circuit d'apprentissage STDP 23 générant un potentiel de poids synaptique dit analogique $V_{w\ analogique}$ qui va à l'entrée d'un circuit mémoire 24 à base de SRAM pour produire le potentiel de poids synaptique binaire $V_w$. Le circuit d'apprentissage STDP comporte d'une part un transistor PMOS 19 alimenté par $VA_{out}$ et chargeant une capacité 21, et d'autre part deux transistors PMOS 17 et 18 en série chargeant une capacité 20, un inverseur 16 reliant le drain du transistor 19 à la grille du transistor 18. Le transistor 17 est alimenté par $VB_{out}$ et a sa grille connectée à $VB_{out\ barre}$ l'état complémentaire de $VB_{out}$. Lors de l'arrivée d'un potentiel d'action du pré-neurone en avance par rapport à celui du post-neurone, la tension de poids synaptique analogique $V_{w\ analogique}$ aux bornes de la capacité 20 augmente. Cette tension est envoyée vers le circuit mémoire 24 à base de SRAM avant que la capacité 20 ne se décharge en l'absence de potentiel d'action. Le circuit mémoire 24 à base de SRAM comprend d'une part une cellule SRAM ayant pour sortie le potentiel de poids synaptique binaire $V_w$ et comportant deux inverseurs 25, 26 dont l'entrée de l'un est connectée à la sortie de l'autre, et d'autre part, deux transistors CMOS 27, 28 dont les canaux drain-source sont en série, recevant sur la grille de l'un d'entre eux la tension analogique $V_{w\ analogique}$, le drain ou la source de ce dernier définissant l'entrée de la cellule SRAMet sur l'autre la tension $VB_{out}$.

Si la tension de poids synaptique analogique $V_{w\ analogique}$ est supérieure à une tension seuil préalablement réglée de la mémoire SRAM, le potentiel de poids synaptique binaire $V_w$ bascule de 0 à $V_{dd}$. Pour un intervalle de temps donné entre le potentiel d'action du pré-neurone et celui du post-neurone, caractérisant le retard du potentiel d'action du post-neurone par rapport au pré-neurone, il faut attendre un certain nombre de pairing (paires de potentiels d'action de pré-neurone et de post-neurone) pour que $V_W$ bascule de 0V à $V_{dd}$, pour un autre intervalle de temps plus élevé, le nombre de pairing requis sera plus important.

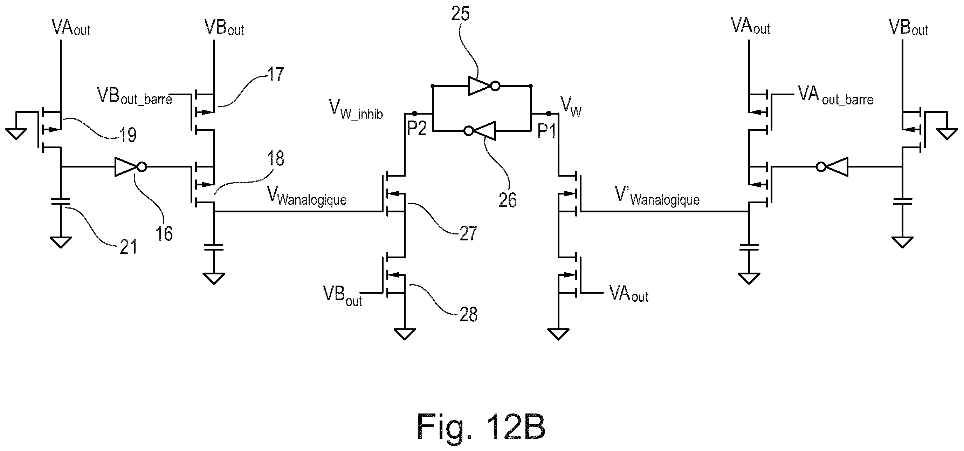

Ce qui vient d'être décrit s'applique au cas d'une synapse excitatrice mais il est à noter qu'un montage symétrique avec les tensions $VA_{out}$ et $VB_{out}$ permutées, peut être utilisé pour contrôler la plasticité d'une synapse inhibitrice, comme illustré à la figure 12B. Dans ce cas, le poids $V_{w\_inhib}$ est prélevé au point de connexion P2 opposé à $V_W$ des inverseurs de la SRAM.

Lorsqu'il n'y a pas de potentiel d'action, $VB_{out}$ = 0V et $VB_{out\_barre}$ = $V_{dd}$. On retrouve le même phénomène que celui de la synapse commutée représentée à la figure 6 où drain et source sont inversés. Ainsi drain et source des transistors 17 et 18 sont inversés et la capacité 20 se décharge au travers de ces transistors. La fuite de grille au niveau du transistor 27 est négligeable devant celle des transistors 17 et 18. Il est à noter que si au préalable, il y a eu une paire de potentiels d'action pré-neurone/post-neurone générée avec le potentiel d'action du pré-neurone en avance sur celui du post-neurone, la mémoire SRAM a commuté et conserve son poids, même si la capacité 20 se décharge.

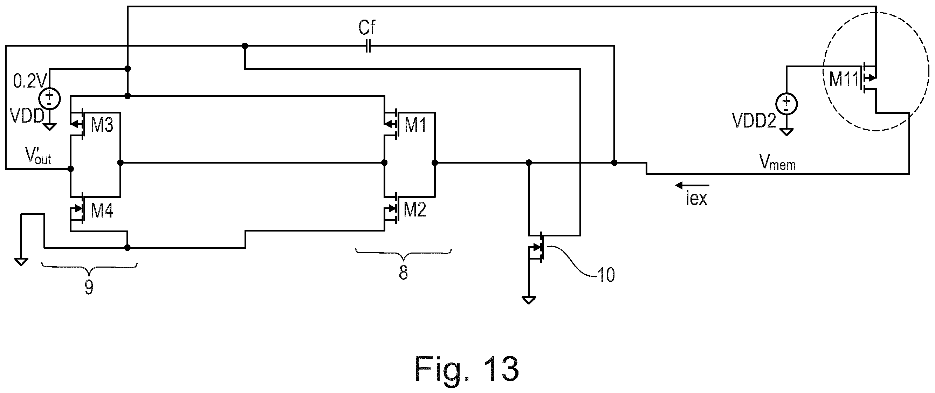

La figure 13 correspond au schéma du circuit AH-N-C illustré à la figure 4 réalisé en technologie CMOS 65 nm. L'inverseur 8 est constitué des transistors M1 et M2. L'inverseur 9 est constitué des transistors M3 et M4. Pour des raisons pratiques (i.e. économie d'un plot au niveau du « layout »), une seule alimentation $V_{dd}$ = 0,2 V alimente AH-N-C ainsi que la transconductance M11 qui sert à exciter ce dernier.

Pour la simulation du circuit, toutes les largeurs de grille des transistors ont été fixées à 120 nm. Toutes les longueurs de grille ont été fixées à 65 nm et la capacité $C_f$ a été fixée à 5 fF.

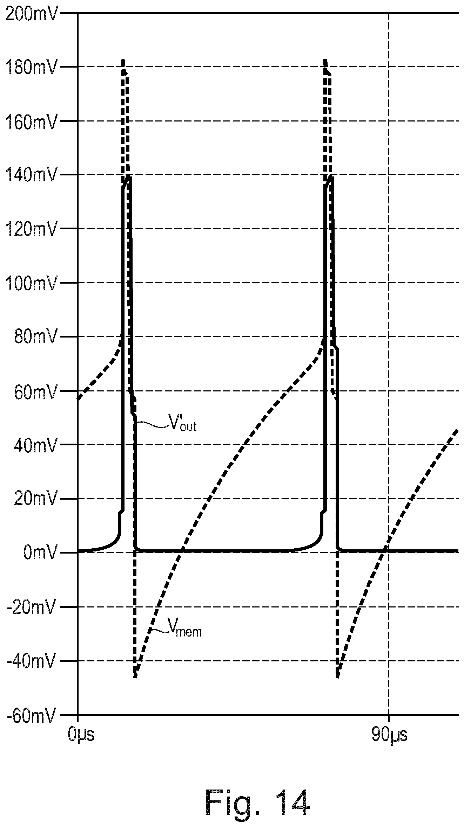

Les formes d'onde obtenues par simulation sont illustrées à la figure 14. Comme on peut le constater, un effet du dimensionnement du circuit se traduit par une tension de sortie $V_{out}$' qui n'atteint pas $V_{dd}$. Elle atteint 140 mV. Il est à noter que les inverseurs 2 et 3 permettent de rehausser le niveau de la tension de sortie à $V_{dd}$ = 200 mV.

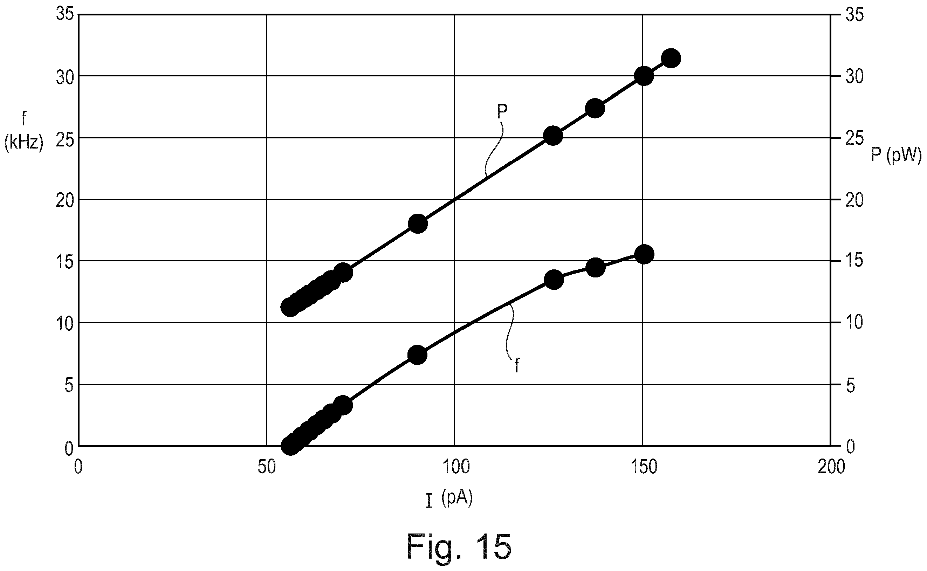

La figure 15 représente les courbes expérimentales de puissance consommée P en pW et de fréquence f en kHz des potentiels d'action provenant de $V_{out}$', en fonction du courant total I délivré par l'alimentation en pA. Afin de faire varier la fréquence, on agit sur la tension Vdd2 du montage de la figure 13.

On remarque qu'en mode statique (f=0), la puissance consommée est légèrement supérieure à 10 pW. Pour le circuit mesuré, la fréquence maximale des potentiels d'action est de 16 kHz. A cette fréquence maximale, la puissance consommée est de 32 pW. Cette valeur de puissance est très proche de celle en mode statique du neurone Morris-Lecar.

Il est à noter que la puissance consommée du circuit AH-N-C ainsi dimensionné est en réalité plus faible, car le courant total I tient compte du courant d'excitation

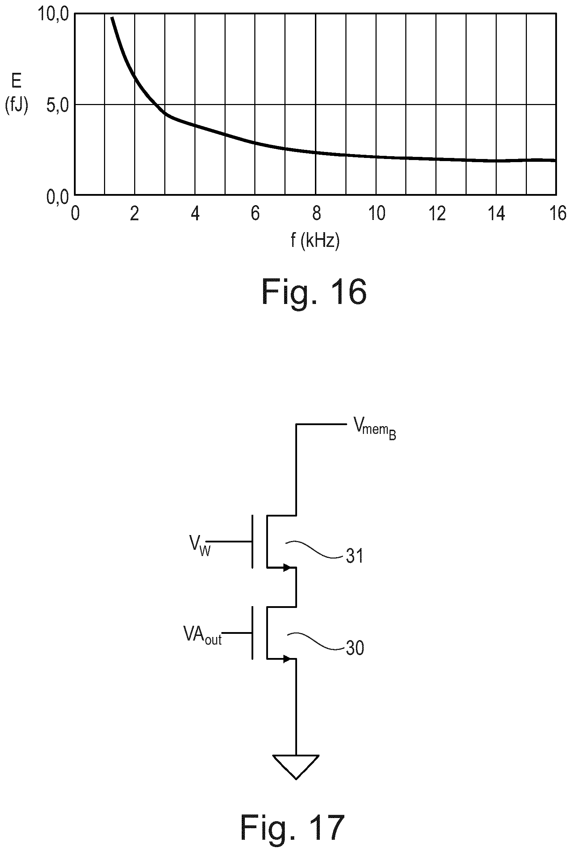

L'énergie, extraite expérimentalement en tenant compte des puissances statique et dynamique, en fJ par potentiel d'action est représentée à la figure 16 en fonction de la fréquence en kHz des potentiels d'action.

Grâce au dimensionnement du circuit AH-N-C, une efficacité énergétique avoisinant les 2 fJ par potentiel d'action est obtenue. Une meilleure valeur serait obtenue si la contribution du courant d'excitation était défalquée. Cette efficacité énergétique est meilleure que pour un circuit ML-N-C. La raison est liée au fait que l'architecture du neurone AH-N-C ne comprend que 5 transistors, et une seule capacité. L'utilisation d'une seule capacité s'avère utile pour gagner en surface d'occupation de silicium et facilite la miniaturisation du circuit.

Le circuit AH-N-C ainsi dimensionné permet aussi de retrouver toutes les fonctionnalités énoncées dans la demande FR 3 050 050 concernant le neurone Morris-Lecar, à savoir la compatibilité avec les synapses excitatrices et inhibitrices, l'émulation du mode rafale et la résonance stochastique.

La figure 17 illustre une synapse inhibitrice, pouvant faire partie du circuit neuronal selon l'invention, comprenant deux transistors CMOS, préférentiellement de type NMOS, 30, 31 dont les canaux drain-source sont en série. Le transistor 30 a sa grille connectée à la tension de sortie $VA_{out}$ du pré-neurone, sa source connectée à la masse et son drain connecté à la source de l'autre transistor 31. Celui-ci a sa grille connectée à un potentiel de poids synaptique $V_w$ et son drain connecté au potentiel de membrane du post neurone.

La synapse artificielle selon l'invention peut servir dans les systèmes neuroinspirés du traitement de l'information, notamment dans le traitement d'images, de vidéo et dans la reconnaissance faciale. Dans ce cas, les éléments du circuit neuronal seront optimisés pour une grande rapidité et/ou une puissance dissipée très faible.

Par ailleurs, le circuit neuronal selon l'invention peut être utilisé dans les applications biomédicales, en tant que synapse biologique artificielle (implant).

## Revendications

1. Circuit neuronal électronique, comportant au moins une synapse excitatrice présentant au moins une entrée de commutation, au moins un pré-neurone présentant une tension de sortie $VA_{out}$ et comportant un inverseur logique générant une tension complémentaire $VA_{out\ barre}$ à partir de la tension de sortie $VA_{out}$, et au moins un post-neurone présentant un potentiel de membrane ($V_{memB}$), le au moins un pré-neurone étant relié au au moins un post-neurone par la au moins une synapse excitatrice, et dans lequel la au moins une synapse excitatrice est alimentée par la tension de sortie $VA_{out}$ et reçoit sur son entrée de commutation la tension complémentaire $VA_{out\_barre}$, la au moins une synapse excitatrice comportant au moins deux transistors (10, 11) à effet de champ dont les canaux drain-source sont en série, de manière à former une chaîne de transistors en série entre un point de potentiel connecté à $VA_{out}$ et un point de potentiel connecté au potentiel de membrane ($V_{memB}$) du au moins un post-neurone, les transistors situés aux extrémités de la chaîne étant qualifiés de « transistors d'extrémité », l'un des transistors d'extrémité (10) ayant une grille définissant l'entrée de commutation et l'autre transistor d'extrémité (11) ayant une grille définissant une entrée de potentiel de poids synaptique ($V_w$).

2. Circuit neuronal électronique selon la revendication 1, lesdits au moins deux transistors (10, 11) à effet de champ étant de type CMOS, le transistor d'extrémité (10) connecté à $VA_{out}$ étant préférentiellement un transistor PMOS, le transistor d'extrémité (11) connecté au potentiel de membrane ($V_{memB}$) du au moins un post-neurone étant de préférence un transistor NMOS, la chaîne de transistors comprenant deux transistors qui constituent les transistors d'extrémité (10, 11), ces transistors ayant leurs sources au même potentiel lorsque $VA_{out} = 0$.

3. Circuit neuronal électronique selon la revendication 2, dans lequel un potentiel de poids synaptique, appliqué à l'entrée de potentiel de poids synaptique ($V_w$), prend une valeur adéquate parmi $V_{dd}$ et 0, lorsque le circuit neuronal électronique est alimenté par une tension $V_{dd}$

4. Circuit neuronal électronique selon la revendication 2 ou 3, comportant au moins un troisième transistor intermédiaire (12) à effet de champ, préférentiellement CMOS, appartenant à la chaîne de transistors et disposé entre lesdits transistors d'extrémité, la grille du troisième transistor étant reliée au drain ou à la source de l'un des transistors d'extrémité.

5. Circuit neuronal électronique selon l'une des revendications 3 et 4, combinée à la revendication 3, la tension d'alimentation $V_{dd}$ dudit circuit étant telle que $0 < V_{dd} < 0,3$ V, mieux $0 < V_{dd} < 0,25$ V, encore mieux $0 < V_{dd} < 0,2$ V.

6. Circuit neuronal électronique selon l'une quelconque des revendications précédentes, le au moins un pré-neurone comportant deux inverseurs (2, 3) en cascade, dénommés premier et second inverseur conformateurs, générant respectivement les tensions $VA_{out\_barre}$ et $VA_{out}$.

7. Circuit neuronal électronique selon l'une quelconque des revendications précédentes, dans lequel un potentiel de poids synaptique binaire ($V_w$) appliqué à l'entrée de potentiel de poids synaptique ($V_w$) est obtenu en sortie d'un circuit (22) de détermination du poids synaptique, ce circuit de détermination du poids synaptique comprenant :

- un circuit mémoire (24), de préférence à base de SRAM, ayant pour entrée une tension analogique $V_{w\ analogique}$ et pour sortie le potentiel de poids synaptique binaire ($V_w$) et comportant :

  ○ une cellule mémoire, de préférence SRAM (« Static Random Access Memory ») comportant deux inverseurs (25, 26) dont l'entrée de l'un est connectée à la sortie de l'autre, et ayant pour sortie un point de connexion (P1) définissant le potentiel de poids synaptique binaire ($V_w$),
  o deux transistors (27, 28) à effet de champ, préférentiellement CMOS, encore plus préférentiellement NMOS, dont les canaux drain-source sont en série, recevant sur la grille de l'un (27) d'entre eux la tension analogique $V_{w\ analogique}$, et le drain ou la source de ce dernier définissant l'entrée de la cellule mémoire, et sur la grille de l'autre transistor (28) un potentiel $VB_{out}$ de sortie du au moins un post-neurone

- un circuit d'apprentissage (23), dit STDP (« Spike Timing Dépendent Plasticity »), comportant de préférence :

  ○ deux transistors (17, 18) à effet de champ, préférentiellement CMOS, encore plus préférentiellement de type PMOS, reliés en série, le premier transistor (17) ayant la source connectée au potentiel $VB_{out}$ de sortie du au moins un post-neurone, la grille connectée à un potentiel complémentaire $VB_{out\ barre}$ de ce potentiel et le drain connecté à la source du deuxième transistor (18), dont le drain est connecté à une borne d'une première capacité (20) intégrant le potentiel de poids synaptique binaire, l'autre borne de cette première capacité (20) étant reliée à la masse, le drain du deuxième transistor fournissant la tension analogique $V_{w\ analogique}$ au circuit mémoire (24),
  o un troisième transistor (19) à effet de champ, préférentiellement CMOS, encore plus préférentiellement PMOS, dont la source est reliée au potentiel $VA_{out}$ du au moins un pré-neurone, la grille est reliée à la masse et le drain relié à une borne d'une deuxième capacité (21) dont l'autre borne est reliée à la masse, et
  o un inverseur (16) dont l'entrée est reliée au drain du troisième transistor (19) et la sortie est reliée à la grille du deuxième transistor (18), comprenant préférentiellement une réplique symétrique du circuit de détermination du poids synaptique dans laquelle les potentiels $VA_{out}$ et $VB_{out}$ sont permutés, la symétrie étant par rapport à la cellule mémoire qui est partagée en commun entre le circuit de détermination du poids synaptique et sa réplique, un potentiel de poids synaptique binaire ($V_{w\_inhib}$) appliqué à une entrée de potentiel de poids synaptique d'une synapse inhibitrice étant prélevé à un point de connexion (P2) opposé au point de connexion (P1) définissant le potentiel de poids synaptique binaire ($V_w$) de la synapse excitatrice.

8. Circuit neuronal électronique selon l'une quelconque des revendications précédentes, le au moins un pré-neurone comportant un sous-circuit d'extension comportant deux inverseurs (2', 3') en cascade, dits de couplage, suivis d'un circuit intégrateur (15) comprenant un transistor (13) à effet de champ, préférentiellement CMOS, et une capacité (14), la grille du transistor (13) étant reliée au drain constituant la sortie des deux inverseurs de couplage (2', 3') en cascade, la source du transistor (13) étant reliée à une première borne de la capacité (14) dont la deuxième borne est reliée à la masse, la sortie du sous-circuit d'extension étant reliée à l'entrée du premier inverseur conformateur (2), le transistor (13) du sous-circuit d'extension étant préférentiellement de type CMOS, de préférence NMOS.

**9.** Circuit neuronal électronique selon l'une quelconque des revendications précédentes, l'un au moins des au moins un pré-neurone et au moins un post-neurone étant de type Morris-Lecar, comportant de préférence

- une capacité dite de membrane ($C_{mem}$) dont l'une des bornes définit un potentiel de membrane ($V_{mem}$),
- un circuit impulsionnel à contre-réaction comportant :

   o un pont à transistors (4, 5) à effet de champ, préférentiellement CMOS, encore plus préférentiellement PMOS (4) et NMOS (5), en série et reliés avec leurs drains au potentiel de membrane ($V_{mem}$), et
   o au moins une capacité, dite de retard (Ck), entre la grille et la source de l'un des transistors (4, 5) du pont, et

- au moins deux inverseurs (36, 37) à effet de champ, préférentiellement CMOS, en cascade, chacun étant constitué de deux transistors, l'entrée du premier inverseur (36) étant reliée à la capacité de membrane ($C_{mem}$) et sa sortie à l'entrée du deuxième inverseur (37) et à la grille de l'un des transistors du pont (4; 5), la sortie du deuxième inverseur (37) étant reliée à la grille de l'autre transistor du pont (4; 5), ou
- au moins trois inverseurs (46, 47, 48) à effet de champ, préférentiellement CMOS, dont deux inverseurs (46, 47) en cascade, chacun étant constitué de deux transistors, l'entrée du premier inverseur (46) étant reliée à la capacité de membrane ($C_{mem}$) et sa sortie à l'entrée du deuxième inverseur (47), la sortie du deuxième inverseur (47) étant reliée à la grille de l'un des transistors (4; 5) du pont, l'entrée du troisième inverseur (48) étant reliée à la capacité de membrane ($C_{mem}$) et la sortie du troisième inverseur CMOS étant reliée à la grille de l'autre transistor (4; 5) du pont.

**10.** Circuit neuronal électronique selon l'une quelconque des revendications 1 à 8, l'un au moins des au moins un pré-neurone et au moins un post-neurone étant de type Axon-Hillock, et comportant de préférence :

- au moins deux inverseurs en cascade (8, 9),
- une capacité de contre-réaction ($C_f$) montée en parallèle desdits au moins deux inverseurs en cascade, et
- un transistor à effet de champ, préférentiellement CMOS, encore plus préférentiellement NMOS, dont le drain définit un potentiel de membrane ($V_{mem}$) qui est l'entrée desdits au moins deux inverseurs en cascade et dont la grille est reliée à leur sortie, la source étant reliée à la masse.

**11.** Circuit neuronal électronique selon l'une quelconque des revendications 6 à 8, combinée à la revendication 9 ou 10, dans lequel l'entrée du premier inverseur conformateur (2) est connectée au potentiel de membrane ($V_{mem}$).

**12.** Circuit neuronal électronique selon l'une quelconque des revendications 9 à 11, les largeurs de grille des transistors du au moins un pré-neurone et/ou du au moins un post-neurone étant comprises entre 60 nm et 10 $\mu$m, préférentiellement entre 120 nm et 2 $\mu$m, les longueurs de grille de ces transistors étant comprises entre 10 nm et 10 $\mu$m, préférentiellement entre 28 nm et 500 nm.

**13.** Circuit neuronal électronique selon l'une quelconque des revendications précédentes, combinée à la revendication 9, comportant :

- au moins deux inverseurs en cascade (8, 9),
- une capacité de contre-réaction ($C_f$) montée en parallèle desdits au moins deux inverseurs en cascade, la capacité de contre-réaction étant comprise entre 1 fF et 1 pF, préférentiellement entre 4fF et 200fF.

**14.** Circuit neuronal électronique selon l'une quelconque des revendications précédentes, combinée à la revendication 8, le transistor (13) du sous-circuit d'extension étant de type CMOS, le circuit neuronal électronique comportant :

- une capacité dite de membrane ($C_{mem}$) dont l'une des bornes définit un potentiel de membrane ($V_{mem}$),
- un circuit impulsionnel à contre-réaction comportant :

o un pont à transistors (4, 5) à effet de champ, préférentiellement CMOS, encore plus préférentiellement PMOS (4) et NMOS (5), en série et reliés avec leurs drains au potentiel de membrane ($V_{mem}$), et

o au moins une capacité, dite de retard (Ck), entre la grille et la source de l'un des transistors (4, 5) du pont, les capacités de membrane ($C_{mem}$) et de retard (Ck) sont comprises entre 1 fF et 1 pF, préférentiellement entre 4fF et 200fF.

15. Circuit neuronal électronique selon l'une quelconque des revendications précédentes, comportant en outre au moins une synapse inhibitrice comprenant au moins deux transistors (30, 31) à effet de champ, préférentiellement CMOS, encore plus préférentiellement NMOS, dont les canaux drain-source sont en série, l'un des deux transistors (30) ayant sa grille connectée à la tension de sortie VA $_{out}$ du au moins un pré-neurone, sa source connectée à la masse et son drain connecté à la source de l'autre transistor (31), ce dernier (31) ayant sa grille connectée à un potentiel de poids synaptique et son drain connecté au potentiel de membrane du au moins un post-neurone.

**Patentansprüche**

1. Elektronischer neuronaler Schaltkreis, der mindestens eine erregende Synapse aufweist, die mindestens einen Schalteingang hat, wobei mindestens ein Prä-Neuron eine Ausgangsspannung $VA_{out}$ hat und einen logischen Inverter aufweist, der eine komplementäre Spannung $VA_{out\_barre}$ ausgehend von der Ausgangsspannung $VA_{out}$ erzeugt, und mindestens ein Post-Neuron ein Membranpotential ($V_{memB}$) hat, wobei das mindestens eine Prä-Neuron mit dem mindestens einen Post-Neuron durch die mindestens eine erregende Synapse verbunden ist, und wobei die mindestens eine erregende Synapse von der Ausgangsspannung $VA_{out}$ gespeist wird und an ihrem Schalteingang die komplementäre Spannung $VA_{out\_barre}$ empfängt, wobei die mindestens eine erregende Synapse mindestens zwei Feldeffekt-Transistoren (10, 11) aufweist, deren Drain-Source-Kanäle in Reihe geschaltet sind, um eine Kette von in Reihe geschalteten Transistoren zwischen einem mit $VA_{out}$ verbundenen Potentialpunkt und einem mit dem Membranpotential ($V_{memB}$) des mindestens einen Post-Neurons verbundenen Potentialpunkt zu bilden, wobei die an den Enden der Kette befindlichen Transistoren als "Endtransistoren" bezeichnet werden, wobei einer der Endtransistoren (10) ein Gate hat, das den Schalteingang definiert, und der andere Endtransistor (11) ein Gate hat, das einen Synapsengewicht-Potentialeingang ($V_w$) definiert.

2. Elektronischer neuronaler Schaltkreis nach Anspruch 1, wobei die mindestens zwei Feldeffekt-Transistoren (10, 11) vom Typ CMOS sind, wobei der mit $VA_{out}$ verbundene Endtransistor (10) vorzugsweise ein PMOS-Transistor ist, wobei der mit dem Membranpotential ($V_{memB}$) des mindestens einen Post-Neurons verbundene Endtransistor (11) vorzugsweise ein NMOS-Transistor ist, wobei die Kette von Transistoren zwei Transistoren enthält, die die Endtransistoren (10, 11) bilden, wobei diese Transistoren ihre Sourcen auf dem gleichen Potential haben, wenn gilt $VA_{out} = 0$.

3. Elektronischer neuronaler Schaltkreis nach Anspruch 2, wobei ein Synapsengewicht-Potential, das an den Synapsengewicht-Potentialeingang ($V_w$) angelegt wird, einen adäquaten Wert zwischen $V_{dd}$ und 0 annimmt, wenn der elektronische neuronale Schaltkreis mit einer Spannung $V_{dd}$ gespeist wird.

4. Elektronischer neuronaler Schaltkreis nach Anspruch 2 oder 3, der mindestens einen dritten Feldeffekt-Zwischentransistor (12), vorzugsweise CMOS, aufweist, der zur Kette von Transistoren gehört und zwischen den Endtransistoren angeordnet ist, wobei das Gate des dritten Transistors mit dem Drain oder der Source eines der Endtransistoren verbunden ist.

5. Elektronischer neuronaler Schaltkreis nach einem der Ansprüche 3 und 4, kombiniert mit Anspruch 3, wobei die Speisespannung $V_{dd}$ des Schaltkreises so ist, dass gilt $0 < V_{dd} < 0,3$ V, besser $0 < V_{dd} < 0,25$ V, noch besser $0 < V_{dd} < 0,2$ V.

6. Elektronischer neuronaler Schaltkreis nach einem der vorhergehenden Ansprüche, wobei das mindestens eine Prä-Neuron zwei Inverter (2, 3) in Kaskadenanordnung aufweist, erster und zweiter konformierender Inverter genannt, die die Spannungen $VA_{out\_barre}$ bzw. $VA_{out}$ erzeugen.

7. Elektronischer neuronaler Schaltkreis nach einem der vorhergehenden Ansprüche, wobei ein binäres Synapsengewicht-Potential ($V_w$) angelegt an den Synapsengewicht-Potentialeingang ($V_w$) am Ausgang eines Bestimmungsschaltkreises (22) des Synapsengewichts erhalten wird, wobei dieser Bestimmungsschaltkreis des Synapsengewichts enthält:

- einen Speicherschaltkreis (24), vorzugsweise auf der Basis von SRAM, der als Eingang eine analoge Spannung $V_{w\ analogique}$ und als Ausgang das binäre Synapsengewicht-Potential ($V_w$) hat und aufweist:

  ○ eine Speicherzelle, vorzugsweise SRAM ("Static Random Access Memory"),die zwei Inverter (25, 26) aufweist, wobei der Eingang des einen mit dem Ausgang des anderen verbunden ist, und als Ausgang einen Verbindungspunkt (P1) hat, der das binäre Synapsengewicht-Potential ($V_w$) definiert,
  ○ zwei Feldeffekt-Transistoren (27, 28), vorzugsweise CMOS, noch bevorzugter NMOS, deren Drain-Source-Kanäle in Reihe geschaltet sind, die am Gate von einem (27) von ihnen die analoge Spannung $V_{w\ analogique}$ empfangen, und der Drain oder die Source dieses letzteren den Eingang der Speicherzelle definiert, und am Gate des anderen Transistors (28) ein Ausgangspotential $VB_{out}$ des mindestens einen Post-Neurons empfangen,

- einen Lernschaltkreis (23), STDP genannt ("Spike Timing Dependent Plasticity"), der vorzugsweise aufweist :

  ○ zwei Feldeffekt-Transistoren (17, 18), vorzugsweise CMOS, noch bevorzugter vom Typ PMOS, in Reihe geschaltet, wobei der erste Transistor (17) die Source mit dem Ausgangspotential $VB_{out}$ des mindestens einen Post-Neurons, das Gate mit einem komplementären Potential $VB_{out\ barre}$ dieses Potentials und den Drain mit der Source des zweiten Transistors (18) verbunden hat, dessen Drain mit einem Anschluss eines ersten Kondensators (20) verbunden ist, der das binäre Synapsengewicht-Potential beinhaltet, wobei der andere Anschluss dieses ersten Kondensators (20) mit Masse verbunden ist, wobei der Drain des zweiten Transistors die analoge Spannung $V_{w\ analogique}$ an den Speicherschaltkreis (24) liefert,
  ○ einen dritten Feldeffekt-Transistor (19), vorzugsweise CMOS, noch bevorzugter PMOS, dessen Source mit dem Potential $VA_{out}$ des mindestens einen Prä-Neurons verbunden ist, das Gate mit Masse verbunden ist und der Drain mit einem Anschluss eines zweiten Kondensators (21) verbunden ist, dessen anderer Anschluss mit Masse verbunden ist, und
  ○ einen Inverter (16), dessen Eingang mit dem Drain des dritten Transistors (19) verbunden und der Ausgang mit dem Gate des zweiten Transistors (18) verbunden ist, der vorzugsweise eine symmetrische Nachbildung des Bestimmungsschaltkreises des Synapsengewichts enthält, in der die Potentiale $VA_{out}$ und $VB_{out}$ vertauscht sind, wobei die Symmetrie sich auf die Speicherzelle bezieht, die zwischen dem Bestimmungsschaltkreis des Synapsengewichts und seiner Nachbildung gemeinsam genutzt wird, wobei ein binäres Synapsengewicht-Potential ($V_{w\_inhib}$) angelegt an einen Synapsengewicht-Potentialeingang einer hemmenden Synapse an einem Verbindungspunkt (P2) entgegengesetzt zum Verbindungspunkt (P1) entnommen wird, der das binäre Synapsengewicht-Potential ($V_w$) der erregenden Synapse definiert.

8. Elektronischer neuronaler Schaltkreis nach einem der vorhergehenden Ansprüche, wobei das mindestens eine Prä-Neuron einen Erweiterungs-Teilschaltkreis aufweist, der zwei Inverter (2', 3') in Kaskadenanordnung, Koppelinverter genannt, gefolgt von einem Integrierschaltkreis (15) aufweist, der einen Feldeffekt-Transistor (13), vorzugsweise CMOS, und einen Kondensator (14) enthält, wobei das Gate des Transistors (13) mit dem den Ausgang der zwei Koppelinverter (2', 3') in Kaskadenanordnung bildenden Drain verbunden ist, wobei die Source des Transistors (13) mit einem ersten Anschluss des Kondensators (14) verbunden ist, dessen zweiter Anschluss mit Masse verbunden ist, wobei der Ausgang des Erweiterungs-Teilschaltkreises mit dem Eingang des ersten konformierenden Inverters (2) verbunden ist, wobei der Transistor (13) des Erweiterungs-Teilschaltkreises vorzugsweise vom Typ CMOS ist, vorzugsweise NMOS.

9. Elektronischer neuronaler Schaltkreis nach einem der vorhergehenden Ansprüche, wobei mindestens eines von dem mindestens einen Prä-Neuron und dem mindestens einen Post-Neuron vom Typ Morris-Lecar ist, der vorzugsweise aufweist

  - einen Membrankondensator genannten Kondensator ($C_{mem}$), von dem einer der Anschlüsse ein Membranpotential ($V_{mem}$) definiert,
  - einen Rückkopplungs-Impulsschaltkreis, der aufweist:

    ○ eine Brücke mit Feldeffekt-Transistoren (4, 5), vorzugsweise CMOS, noch bevorzugter PMOS (4) und NMOS (5), in Reihe und mit ihren Drains mit dem Membranpotential ($V_{mem}$) verbunden, und
    ○ mindestens einen Kondensator, Verzögerungskondensator genannt (Ck), zwischen dem Gate und der Source eines der Transistoren (4, 5) der Brücke, und

  - mindestens zwei Feldeffekt-Inverter (36, 37), vorzugsweise CMOS, in Kaskade, die je aus zwei Transistoren bestehen, wobei der Eingang des ersten Inverters (36) mit dem Membrankondensator ($C_{mem}$) und sein Ausgang mit dem Eingang des zweiten Inverters (37) und mit dem Gate eines der Transistoren der Brücke (4; 5) verbunden ist, wobei der Ausgang des zweiten Inverters (37) mit dem Gate des anderen Transistors der Brücke (4; 5) verbunden ist, oder

- mindestens drei Feldeffekt-Inverter (46, 47, 48), vorzugsweise CMOS, davon zwei Inverter (46, 47) in Kaskade, die je aus zwei Transistoren bestehen, wobei der Eingang des ersten Inverters (46) mit dem Membrankondensator ($C_{mem}$) und sein Ausgang mit dem Eingang des zweiten Inverters (47) verbunden ist, wobei der Ausgang des zweiten Inverters (47) mit dem Gate eines der Transistoren (4; 5) der Brücke verbunden ist, wobei der Eingang des dritten Inverters (48) mit dem Membrankondensator ($C_{mem}$) und der Ausgang des dritten CMOS-Inverters mit dem Gate des anderen Transistors (4; 5) der Brücke verbunden ist.

10. Elektronischer neuronaler Schaltkreis nach einem der Ansprüche 1 bis 8, wobei mindestens eines von dem mindestens einen Prä-Neuron und mindestens einen Post-Neuron vom Typ Axon-Hillock ist, und vorzugsweise aufweist:

- mindestens zwei Inverter in Kaskade (8, 9),
- einen Rückkopplungskondensator ($C_f$) mit den mindestens zwei Invertern in Kaskade parallelgeschaltet, und
- einen Feldeffekt-Transistor, vorzugsweise CMOS, noch bevorzugter NMOS, dessen Drain ein Membranpotential ($V_{mem}$) definiert, das der Eingang der mindestens zwei Inverter in Kaskade ist und dessen Gate mit ihrem Ausgang verbunden ist, wobei die Source mit Masse verbunden ist.

11. Elektronischer neuronaler Schaltkreis nach einem der Ansprüche 6 bis 8, kombiniert mit Anspruch 9 oder 10, wobei der Eingang des ersten konformierenden Inverters (2) mit dem Membranpotential ($V_{mem}$) verbunden ist.

12. Elektronischer neuronaler Schaltkreis nach einem der Ansprüche 9 bis 11, wobei die Gate-Breiten der Transistoren des mindestens einen Prä-Neurons und/oder des mindestens einen Post-Neurons zwischen 60 nm und 10 $\mu$m liegen, vorzugsweise zwischen 120 nm und 2 $\mu$m, wobei die Gate-Längen dieser Transistoren zwischen 10 nm und 10 $\mu$m liegen, vorzugsweise zwischen 28 nm und 500 nm.

13. Elektronischer neuronaler Schaltkreis nach einem der vorhergehenden Ansprüche, kombiniert mit Anspruch 9, der aufweist:

- mindestens zwei Inverter in Kaskade (8, 9),
- einen Rückkopplungskondensator (Cf), der mit den mindestens zwei Invertern in Kaskade parallelgeschaltet ist,

wobei die Rückkopplungskapazität zwischen 1 fF und 1 pF, vorzugsweise zwischen 4 fF und 200 fF liegt.

14. Elektronischer neuronaler Schaltkreis nach einem der vorhergehenden Ansprüche, kombiniert mit Anspruch 8, wobei der Transistor (13) des Erweiterungs-Teilschaltkreises vom Typ CMOS ist, wobei der elektronische neuronale Schaltkreis aufweist :

- einen so genannten Membrankondensator ($C_{mem}$), von dem ein Anschluss ein Membranpotential ($V_{mem}$) definiert,
- einen Rückkopplungs-Impulsschaltkreis, der aufweist :

  ◦ eine Brücke mit Feldeffekt-Transistoren (4, 5), vorzugsweise CMOS, noch bevorzugter PMOS (4) und NMOS (5), in Reihe und mit ihren Drains mit dem Membranpotential ($V_{mem}$) verbunden, und
  ◦ mindestens einen so genannten Verzögerungskondensator, (Ck) zwischen dem Gate und der Source eines der Transistoren (4, 5) der Brücke,

wobei die Membran- ($C_{mem}$) und Verzögerungskapazitäten (Ck) zwischen 1 fF und 1 pF liegen, vorzugsweise zwischen 4 fF und 200 fF.

15. Elektronischer neuronaler Schaltkreis nach einem der vorhergehenden Ansprüche, der außerdem mindestens eine hemmende Synapse aufweist, die mindestens zwei Feldeffekt-Transistoren (30, 31), vorzugsweise CMOS, noch bevorzugter NMOS, aufweist, deren Drain-Source-Kanäle in Reihe geschaltet sind, wobei einer der zwei Transistoren (30) sein Gate mit der Ausgangsspannung $VA_{out}$ des mindestens einen Prä-Neurons verbunden, seine Source mit Masse verbunden und seinen Drain mit der Source des anderen Transistors (31) verbunden hat, wobei letzterer (31) sein Gate mit einem Synapsengewicht-Potential und seinen Drain mit dem Membranpotential des mindestens

**14**

einen Post-Neurons verbunden hat.

**Claims**

1. Electronic neural circuit, comprising at least one excitatory synapse having at least one switching input, at least one pre-neuron having an output voltage $VA_{out}$ and comprising a logic inverter generating a complementary voltage $VA_{out\_bar}$ on the basis of the output voltage $VA_{out}$, and at least one post-neuron having a membrane potential ($V_{memB}$), the at least one pre-neuron being connected to the at least one post-neuron by the at least one excitatory synapse, and wherein the at least one excitatory synapse is supplied with the output voltage $VA_{out}$ and receives, at its switching input, the complementary voltage $VA_{out\_bar}$, the at least one excitatory synapse comprising at least two field-effect transistors (10, 11), the drain-source channels of which are in series, so as to form a chain of transistors in series between a potential point connected to $VA_{out}$ and a potential point connected to the membrane potential ($V_{-memB}$) of the at least one post-neuron, the transistors located at the ends of the chain being described as "end transistors", one of the end transistors (10) having a gate defining the switching input and the other end transistor (11) having a gate defining an synaptic weight potential input ($V_w$).

2. Electronic neural circuit according to Claim 1, said at least two field-effect transistors (10, 11) being of CMOS type, the end transistor (10) connected to $VA_{out}$ preferably being a PMOS transistor and the end transistor (11) connected to the membrane potential ($V_{memB}$) of the at least one post-neuron preferably being an NMOS transistor, the chain of transistors comprising two transistors which constitute the end transistors (10, 11), these transistors having their sources at the same potential when $VA_{out} = 0$.

3. Electronic neural circuit according to Claim 2, wherein a synaptic weight potential, applied to the synaptic weight potential input ($V_w$), takes an appropriate value between $V_{dd}$ and 0 when the electronic neural circuit is supplied with a voltage $V_{dd}$.

4. Electronic neural circuit according to Claim 2 or 3, comprising at least a third, intermediate field-effect, preferably CMOS, transistor (12) belonging to the chain of transistors and arranged between said end transistors, the gate of the third transistor being connected to the drain or to the source of one of the end transistors.

5. Electronic neural circuit according to either of Claim 3 and Claim 4, combined with Claim 3, the supply voltage $V_{dd}$ of said circuit being such that $0 < V_{dd} < 0.3$ V, better still $0 < V_{dd} < 0.25$ V, and even better still $0 < V_{dd} < 0.2$ V.

6. Electronic neural circuit according to any one of the preceding claims, the at least one pre-neuron comprising two inverters (2, 3) in a cascade, named first and second conforming inverters, generating the voltages $VA_{out\_bar}$ and $VA_{out}$, respectively.

7. Electronic neural circuit according to any one of the preceding claims, wherein a binary synaptic weight potential ($V_w$) applied to the synaptic weight potential input ($V_w$) is obtained at the output of a circuit (22) for determining the synaptic weight, this circuit for determining the synaptic weight comprising:

   - a, preferably SRAM-based, memory circuit (24) having as input an analogue voltage $V_{w\ analogue}$ and as output the binary synaptic weight potential ($V_w$) and comprising:

      ◦ a, preferably SRAM (static random-access memory), memory cell comprising two inverters (25, 26), the input of one of which is connected to the output of the other, and having as output a connection point (P1) defining the binary synaptic weight potential ($V_w$),
      ◦ two field-effect, preferably CMOS, even more preferably NMOS, transistors (27, 28), the drain-source channels of which are in series, receiving, at the gate of one (27) of them, the analogue voltage $V_{w\ analogue}$, and the drain or the source of the latter defining the input of the memory cell, and, at the gate of the other transistor (28), an output potential $VB_{out}$ of the at least one post-neuron,

   - a learning circuit (23), referred to as an STDP (spike-timing-dependent plasticity) learning circuit, preferably comprising:

      ◦ two field-effect, preferably CMOS, even more preferably PMOS, transistors (17, 18) connected in series, the first transistor (17) having its source connected to the output potential $VB_{out}$ of the at least one post-neuron, its gate connected to a complementary potential $VB_{out\,bar}$ of this potential and its drain connected to the source of the second transistor (18), the drain of which is connected to a terminal of a first capacitor (20) integrating the binary synaptic weight potential, the other terminal of this first capacitor (20) being connected to ground, the drain of the second transistor delivering the analogue voltage $V_{w\,analogue}$ to the memory circuit (24),

◦ a third field-effect, preferably CMOS, even more preferably PMOS, transistor (19) with its source connected to the potential $VA_{out}$ of the at least one pre-neuron, its gate connected to ground and its drain connected to one terminal of a second capacitor (21), the other terminal of which is connected to ground, and

◦ an inverter (16), the input of which is connected to the drain of the third transistor (19) and the output of which is connected to the gate of the second transistor (18),

preferably comprising a symmetrical replica of the circuit for determining the synaptic weight in which the potentials $VA_{out}$ and $VB_{out}$ are swapped, the symmetry being with respect to the memory cell, which is shared between the circuit for determining the synaptic weight and its replica, a binary synaptic weight potential ($V_{w\_inhib}$) applied to an synaptic weight potential input of an inhibitory synapse being tapped off at a connection point (P2) which is opposite the connection point (P1) defining the binary synaptic weight potential ($V_w$) of the excitatory synapse.

8. Electronic neural circuit according to any one of the preceding claims, the at least one pre-neuron comprising an extension sub-circuit comprising two inverters (2', 3') in a cascade, referred to as coupling inverters, followed by an integrating circuit (15) comprising a field-effect, preferably CMOS, transistor (13) and a capacitor (14), the gate of the transistor (13) being connected to the drain constituting the output of the two coupling inverters (2', 3') in a cascade, the source of the transistor (13) being connected to a first terminal of the capacitor (14), the second terminal of which is connected to ground, the output of the extension sub-circuit being connected to the input of the first conforming inverter (2), the transistor (13) of the extension sub-circuit preferably being of CMOS type, preferably NMOS.

9. Electronic neural circuit according to any one of the preceding claims, at least one of the at least one pre-neuron and at least one post-neuron being of Morris-Lecar type, preferably comprising

- a capacitor referred to as a membrane capacitor ($C_{mem}$), one of the terminals of which defines a membrane potential ($V_{mem}$),
- a pulse feedback circuit comprising:

◦ a bridge of field-effect, preferably CMOS, even more preferably PMOS (4) and NMOS (5), transistors (4, 5) in series and connected via their drains to the membrane potential ($V_{mem}$), and
◦ at least one capacitor, referred to as a delay capacitor (Ck), between the gate and the source of one of the transistors (4, 5) of the bridge, and

- at least two field-effect, preferably CMOS, inverters (36, 37) in a cascade, each consisting of two transistors, the input of the first inverter (36) being connected to the membrane capacitor ($C_{mem}$) and its output to the input of the second inverter (37) and to the gate of one of the transistors of the bridge (4; 5), the output of the second inverter (37) being connected to the gate of the other transistor of the bridge (4; 5), or
- at least three field-effect, preferably CMOS, inverters (46, 47, 48), including two inverters (46, 47) in a cascade, each consisting of two transistors, the input of the first inverter (46) being connected to the membrane capacitor ($C_{mem}$) and its output to the input of the second inverter (47), the output of the second inverter (47) being connected to the gate of one of the transistors (4; 5) of the bridge, the input of the third inverter (48) being connected to the membrane capacitor ($C_{mem}$) and the output of the third CMOS inverter being connected to the gate of the other transistor (4; 5) of the bridge.

10. Electronic neural circuit according to any one of Claims 1 to 8, at least one of the at least one pre-neuron and at least one post-neuron being of axon hillock type, and preferably comprising:

- at least two inverters in a cascade (8, 9),
- a feedback capacitor ($C_f$) connected in parallel to said at least two inverters in a cascade, and
- a field-effect, preferably CMOS, even more preferably NMOS, transistor, the drain of which defines a membrane potential ($V_{mem}$) which is the input of said at least two inverters in a cascade and the gate of which is connected to their output, the source being connected to ground.

**11.** Electronic neural circuit according to any one of Claims 6 to 8, combined with Claim 9 or 10, wherein the input of the first conforming inverter (2) is connected to the membrane potential ($V_{mem}$).

**12.** Electronic neural circuit according to any one of Claims 9 to 11, the gate widths of the transistors of the at least one pre-neuron and/or of the at least one post-neuron being between 60 nm and 10 $\mu$m, preferably between 120 nm and 2 $\mu$m, and the gate lengths of these transistors being between 10 nm and 10 $\mu$m, preferably between 28 nm and 500 nm.

**13.** Electronic neural circuit according to any one of the preceding claims, combined with Claim 9, comprising:

- at least two inverters in a cascade (8, 9),
- a feedback capacitor ($C_f$) connected in parallel to said at least two inverters in a cascade,

the feedback capacitor being between 1 fF and 1 pF, preferably between 4 fF and 200 fF.

**14.** Electronic neural circuit according to any one of the preceding claims, combined with Claim 8, the transistor (13) of the extension sub-circuit being of CMOS type, the electronic neural circuit comprising:

- a capacitor referred to as a membrane capacitor ($C_{mem}$), one of the terminals of which defines a membrane potential ($V_{mem}$),
- a pulse feedback circuit comprising:

  ○ a bridge of field-effect, preferably CMOS, even more preferably PMOS (4) and NMOS (5), transistors (4, 5) in series and connected via their drains to the membrane potential ($V_{mem}$), and
  ○ at least one capacitor, referred to as a delay capacitor (Ck), between the gate and the source of one of the transistors (4, 5) of the bridge,

the membrane capacitor ($C_{mem}$) and delay capacitor (Ck) being between 1 fF and 1 pF, preferably between 4 fF and 200 fF.

**15.** Electronic neural circuit according to any one of the preceding claims, further comprising at least one inhibitory synapse comprising at least two field-effect, preferably CMOS, even more preferably NMOS, transistors (30, 31), the drain-source channels of which are in series, one of the two transistors (30) having its gate connected to the output voltage $VA_{out}$ of the at least one pre-neuron, its source connected to ground and its drain connected to the source of the other transistor (31), the latter (31) having its gate connected to a synaptic weight potential and its drain connected to the membrane potential of the at least one post-neuron.

Vdd

S

$V_{SDp}$

$VA_{out\ barre}$

$V_W$

Iex

$V_{mem_B}$

ETAT DE L'ART

Fig. 1

Vdd

Vdd

1

Pre-N

S

Post-N

Fig. 2

ML - N - C

VDD

37

36

2

3

4

$VA_{out\ barre}$

$VA_{out}$

$I_{Na}$

$V_{mem_A}$

$I_K$

$C_{mem}$

$C_K$

5

Fig. 3A

ML - N - C

Vdd

## Fig. 3B

AH - N - C

## Fig. 4

Fig. 5

Fig. 6

Fig. 7

Fig. 8

EP 3 794 514 B1

VA$_{out}$

S

VA$_{out\ barre}$

ℓ$_1$

10

12

ℓ$_2$

V$_W$

11

Iex

# Fig. 9

15

2'    3'    13    2    3

Pre - N - C

V$_{mem_A}$

V$_1$

VA$_{out}$

VA$_{out\ barre}$

V$_W$

Iex

14

V$_{mem_B}$

S

# Fig. 10

Fig. 11

Fig. 12A

Fig. 12B

Fig. 13

Fig. 14

Fig. 15

Fig. 16

Fig. 17

## RÉFÉRENCES CITÉES DANS LA DESCRIPTION

**Documents brevets cités dans la description**

- FR 3050050

**Littérature non-brevet citée dans la description**

- **C. MEAD et al.** *Neuromorphic electronic systems,* 1990
- **E. FARQUHAR et al.** *A bio-physically inspired silicon neuron,* 2005
- **J. ARTHUR ; K. BOAHEN.** Leaming in silicon: timing is everything. *Advances in Neuronal Information Processing Systems,* 2006
- **PATIL et al.** *Neural circuits for touch-induced locomotion in Caenorhabditis elegans ; actes de IJCNN'15,* 2015